# EUROPEAN PATENT APPLICATION

(11) **EP 4 307 360 A1**
(43) Date of publication of application: **17.01.2024**
(21) Application number: 22766911.6
(22) Date of filing: 01.03.2022
(51) Int. Cl.: H01L 23/12, H01L 25/10, H01L 25/11, H01L 25/18

(54) **SEMICONDUCTOR DEVICE, METHOD FOR MANUFACTURING SEMICONDUCTOR DEVICE, AND ELECTRONIC DEVICE**

(30) Priority: 09.03.2021 JP 2021037874
(71) Applicant: Sony Semiconductor Solutions Corporation, Atsugi-shi, Kanagawa 243-0014 (JP)
(72) Inventor: SHIGETOSHI, Takushi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/008539
(87) International publication number: WO 2022/190952

(57) **Abstract**

Provided are a semiconductor device that can be manufactured with higher accuracy and higher yield without the need of a complicated process such as a process of exposing a through mold via with an external connection terminal mounted, a method for manufacturing a semiconductor device, and an electronic device including the semiconductor device.

A configuration includes: a first package including a die of an integrated circuit, a protective film disposed on an upper surface of the die, the protective film being larger in area than the die, a first molding material covering an outer periphery of the die, a plurality of through mold vias formed penetrating the first molding material and the protective film, the plurality of through mold vias being smaller in penetrating diameter of the protective film than the first molding material, a seed layer formed on upper end portions of the through mold vias and peripheral side surfaces of the through mold vias, and an external connection terminal connected to lower end portions of the through mold vias; and a second package placed on an upper surface of the protective film of the first package and connected to the upper end portions of the through mold vias.

## Description

### TECHNICAL FIELD

The present disclosure relates to a semiconductor device according to high integration of a semiconductor package, particularly package on package (PoP) by which a fan-out chip size package (FO-CSP) and another package are stacked and mounted, a method for manufacturing a semiconductor device, and an electronic device including the semiconductor device.

### BACKGROUND ART

In the related art, an increase in performance of semiconductor elements has been achieved by miniaturization of transistors and wirings. However, as miniaturization progresses, a decrease in the pace of performance improvement due to side effects of parasitic elements and the like, and an increase in development and manufacturing cost have become problems. Therefore, in recent years, dies or packages of integrated circuits having different functions are each manufactured by an optimal process and are three-dimensionally stacked using through electrodes and the like, thereby developing integration and high performance of semiconductor elements.

Accordingly, as an example of high integration of semiconductor packages, packages based on, for example, package on package (PoP) by which a package and another package are stacked on one another and mounted, fine pitch ball grid array (FBGA), wafer level chip size package (WLCSP), further developed fan out wafer chip level package (FOWLP), and the like have been announced.

When dies or packages of integrated circuits are three-dimensionally integrated, it is, however, necessary to reduce the thickness of a substrate, which causes a lack of mechanical strength, warping due to stress generated by the lack of mechanical strength, or the like, and challenges include a manufacturing yield, ensuring of product characteristics, an increase in reliability, and the like.

Therefore, Patent Document 1 is disclosed as a related art for preventing a lack of mechanical strength due to a reduction in thickness of a substrate, warpage due to stress, and the like.

Patent Document 1 proposes a package structure in which a protective film is laminated on a back surface side of a die in order to improve a mechanical strength of FO-CSP as compared with a PoP structure using FO-CSP as a lower layer.

Specifically, in a package including the die, the protective film is laminated on the back surface of the die, a molding material is provided on a side surface of the die, a via penetrating the molding material is provided, and the through via is formed flush with the protective film. That is, by bonding the protective film to the back surface of the die with an adhesive and connecting the protective film to a re-distribution layer (RDL) on the front surface side, the protective film exerts an effect of a reinforcing material to reduce warpage and reduce bonding failure at the time of assembly.

### CITATION LIST

### PATENT DOCUMENT

Patent Document 1: US Patent No. 9922903

### SUMMARY OF THE INVENTION

### PROBLEMS TO BE SOLVED BY THE INVENTION

In the method described in the technique disclosed in Patent Document 1, it is, however, necessary to perform a process of opening (process of exposing) a through mold via with an external connection terminal such as a solder ball mounted, and thus a complicated process is required. For this reason, there is a problem that manufacturing accuracy is required, and an improvement in yield is required.

The present disclosure has been made in view of such problems, and the formation of the through mold via penetrating the molding material and the protective film is performed after the die is bonded to the protective film and filled with the molding material in the related art, but the formation of the through mold via is performed before the die is bonded to the protective film according to the present disclosure. It is therefore an object of the present disclosure to provide a semiconductor device that can be manufactured with higher accuracy and higher yield without the need of a complicated process such as a process of exposing a through mold via with an external connection terminal mounted, a method for manufacturing a semiconductor device, and an electronic device including the semiconductor device.

### SOLUTIONS TO PROBLEMS

The present disclosure has been made to solve the above-described problems, and a first aspect of the present disclosure is a semiconductor device including: a first package including a die of an integrated circuit, a protective film disposed on an upper surface of the die, the protective film being larger in area than the die, a first molding material covering an outer periphery of the die, a plurality of through mold vias formed penetrating the first molding material and the protective film, the plurality of through mold vias being smaller in penetrating diameter of the protective film than the first molding material, a seed layer formed on upper end portions of the through mold vias and peripheral side surfaces of the through mold vias, and an external connection terminal connected to lower end portions of the through mold vias; and a second package placed on an upper surface of the protective film of the first package and connected to the upper end portions of the through mold vias.

Furthermore, in the first aspect of present disclosure, the protective film disposed on the upper surface of the die may be formed such that a surface with which the die comes into contact is thinner.

Furthermore, in the first aspect, the protective film disposed on the upper surface of the die may be formed such that a surface with which the die comes into contact is a through hole into which the die can be fitted.

Furthermore, in the first aspect, at least one second re-distribution layer that is connected to the through mold vias may be formed on the upper surface of the protective film.

Furthermore, in the first aspect, a connection terminal of the second package may be formed on the second re-distribution layer.

Furthermore, in the first aspect, a through electrode that penetrates the die to connect to a wiring layer of the die may be bored.

Furthermore, in the first aspect, the through mold vias and the connection terminal of the second package may be connected in the protective film.

The external connection terminal may be formed connecting to the lower end portions of the through mold vias via a first re-distribution layer.

A second aspect of the present disclosure is a method for manufacturing a semiconductor device including: a process of forming a protective film and forming a through mold via in the protective film; a process of bonding, after the through mold via is formed, a die of an integrated circuit to a surface of the protective film in which the through mold via is formed to form a first package on a surface side where the die is bonded; and a process of forming a second package on a surface side of the first package where the die is not bonded.

Furthermore, in the second aspect, the process of forming a protective film and forming a through mold via in the protective film may include a process of applying an adhesive to a support substrate, a process of forming the protective film on an upper surface of the adhesive, a process of patterning the protective film according to a planar shape of an upper end portion of the through mold via and a planar shape of the die, a process of forming a seed layer on an upper surface of the protective film that has been patterned, and a process of forming a resist mask on an upper surface of the seed layer according to a shape of a lower end portion of the through mold via.

Furthermore, in the second aspect, the process of forming a protective film and forming a through mold via in the protective film may include a process of applying an adhesive to a support substrate, a process of forming a second re-distribution layer on an upper surface of the adhesive, a process of forming the protective film on an upper surface of the second re-distribution layer, a process of patterning the protective film, a process of forming a seed layer on an upper surface of the protective film that has been patterned, and a process of forming a resist mask on an upper surface of the seed layer according to a shape of the through mold via.

Furthermore, in the second aspect, the process of bonding, after the through mold via is formed, a die of an integrated circuit to a surface of the protective film in which the through mold via is formed to form a first package on a surface side where the die is bonded may include a process of forming the through mold via on the protective film, a process of bonding the die to a surface on which the through mold via is formed, a process of forming a through electrode penetrating and connecting the die and the wiring layer of the die, a process of filling an outer periphery of the through mold via and an outer periphery of the die with a first molding material, and a process of forming a first re-distribution layer on a surface side where the die is not bonded.

Furthermore, in the second aspect, the process of forming a second package on a surface side of the first package where the die is not bonded may include a process of bonding at least one another die onto a substrate and connecting a pad of the another die and a pad of the substrate, a process of filling an outer periphery of the another die with a second molding material, a process of forming a connection terminal on a surface side of the substrate where the another die is not bonded, and a process of connecting the connection terminal formed in the second package and the upper end portion of the through mold via formed in the first package.

Furthermore, in the second aspect, the process of connecting the connection terminal formed in the second package and the upper end portion of the through mold via formed in the first package may include a process of placing the second package on the first package, a process of joining the upper end portion of the through mold via formed in the first package and the connection terminal formed in the second package together with the upper end portion of the through mold via and the connection terminal facing each other, and a process of establishing connection by mechanical stress or mechanical stress and heating in the joined state.

A third aspect of the present disclosure is an electronic device including a semiconductor device, the semiconductor device including: a first package including a die of an integrated circuit, a protective film disposed on an upper surface of the die, the protective film being larger in area than the die, a first molding material covering an outer periphery of the die, a plurality of through mold vias formed penetrating the first molding material and the protective film, the plurality of through mold vias being smaller in penetrating diameter of the protective film than the first molding material, a seed layer formed on upper end portions of the through mold vias and peripheral side surfaces of the through mold vias, and an external connection terminal connected to lower end portions of the through mold vias; and a second package placed on an upper surface of the protective film of the first package and connected to the upper end portions of the through mold vias.

According to the above-described aspects, it is possible to form the through mold via penetrating the first molding material and the protective film before bonding the die to the protective film. Furthermore, it is possible to manufacture a semiconductor device including the first package and the second package bonded to the upper surface of the protective film of the first package and electrically connected by the through mold via.

According to the present disclosure, the through mold via penetrating the first molding material and the protective film is formed before the die of the integrated circuit is bonded to the first molding material and the protective film. It is therefore possible to provide the semiconductor device that can be manufactured with higher accuracy and higher yield without the need of a complicated process such as a process of exposing a through mold via with an external connection terminal mounted, the method for manufacturing a semiconductor device, and the electronic device including the semiconductor device.

### BRIEF DESCRIPTION OF DRAWINGS

Fig. 1 is a schematic cross-sectional view of a first embodiment of a semiconductor device according to the present disclosure.
Fig. 2 is an enlarged cross-sectional view of a through mold via of the first embodiment of the semiconductor device according to the present disclosure.
Fig. 3 is a process explanatory diagram of a method for manufacturing the first embodiment of the semiconductor device according to the present disclosure (part 1).
Fig. 4 is a process explanatory diagram of the method for manufacturing the first embodiment of the semiconductor device according to the present disclosure (part 2).
Fig. 5 is a process explanatory diagram of the method for manufacturing the first embodiment of the semiconductor device according to the present disclosure (part 3).
Fig. 6 is a process explanatory diagram of the method for manufacturing the first embodiment of the semiconductor device according to the present disclosure (part 4).
Fig. 7 is a process explanatory diagram of the method for manufacturing the first embodiment of the semiconductor device according to the present disclosure (part 5).
Fig. 8 is a process explanatory diagram of the method for manufacturing the first embodiment of the semiconductor device according to the present disclosure (part 6).
Fig. 9 is a process explanatory diagram of the method for manufacturing the first embodiment of the semiconductor device according to the present disclosure (part 7).
Fig. 10 is a process explanatory diagram of the method for manufacturing the first embodiment of the semiconductor device according to the present disclosure (part 8).
Fig. 11 is a process explanatory diagram of the method for manufacturing the first embodiment of the semiconductor device according to the present disclosure (part 9).
Fig. 12 is a process explanatory diagram of the method for manufacturing the first embodiment of the semiconductor device according to the present disclosure (part 10).
Fig. 13 is a process explanatory diagram of the method for manufacturing the first embodiment of the semiconductor device according to the present disclosure (part 11).
Fig. 14 is a process explanatory diagram of the method for manufacturing the first embodiment of the semiconductor device according to the present disclosure (part 12).
Fig. 15 is a process explanatory diagram of the method for manufacturing the first embodiment of the semiconductor device according to the present disclosure (part 13).
Fig. 16 is a schematic cross-sectional view of a second embodiment of the semiconductor device according to the present disclosure.
Fig. 17 is a schematic cross-sectional view of a third embodiment of the semiconductor device according to the present disclosure.
Fig. 18 is a schematic cross-sectional view of a fourth embodiment of the semiconductor device according to the present disclosure.
Fig. 19 is a schematic cross-sectional view of a fifth embodiment of the semiconductor device according to the present disclosure.
Fig. 20 is a process explanatory diagram of a method for manufacturing the fifth embodiment of the semiconductor device according to the present disclosure (part 1).
Fig. 21 is a process explanatory diagram of the method for manufacturing the fifth embodiment of the semiconductor device according to the present disclosure (part 2).
Fig. 22 is a process explanatory diagram of the method for manufacturing the fifth embodiment of the semiconductor device according to the present disclosure (part 3).
Fig. 23 is a block diagram of an electronic device including the semiconductor device according to the present disclosure.

### MODE FOR CARRYING OUT THE INVENTION

Next, a mode for carrying out the present disclosure (hereinafter, referred to as a "embodiment") will be described in the following order with reference to the drawings. Note that, in the following drawings, the same or similar parts are denoted by the same or similar reference numerals. However, the drawings are schematic, and dimensional ratios and the like of the respective parts do not necessarily match actual ones. Furthermore, it goes without saying that dimensional relationships and ratios are partly different between the drawings.
1. First embodiment of semiconductor device according to the present disclosure
2. Method for manufacturing first embodiment of semiconductor device according to the present disclosure
3. Second embodiment of semiconductor device according to the present disclosure and method for manufacturing the same
4. Third embodiment of semiconductor device according to the present disclosure and method for manufacturing the same
5. Fourth embodiment of semiconductor device according to the present disclosure and method for manufacturing the same
6. Fifth embodiment of semiconductor device according to the present disclosure and method for manufacturing the same
7. Electronic device including semiconductor device according to present disclosure

### <1. First embodiment of semiconductor device according to present disclosure>

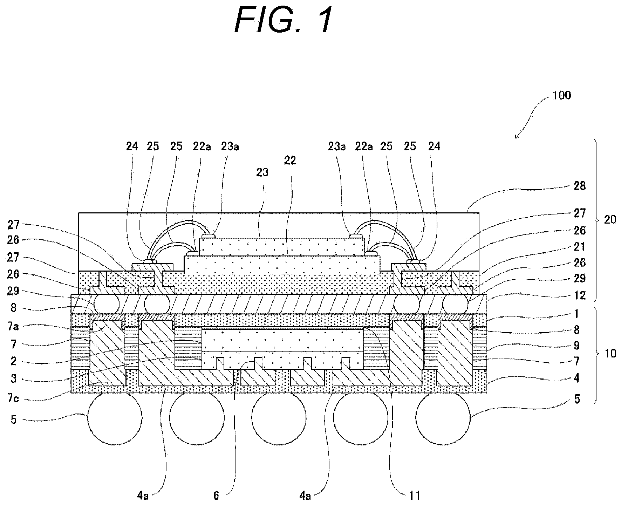

Fig. 1 is a schematic cross-sectional view of a first embodiment of a semiconductor device 100 according to the present disclosure. As illustrated in the drawing, the semiconductor device 100 includes a first package 10 and a second package 20 placed on and connected to the first package 10.

The first package 10 has a protective film 1 disposed thereon, and a die 2 of an integrated circuit is bonded to an approximately lower center of the protective film 1 by an adhesive 11. The die 2 has a wiring layer 3 disposed thereunder. The die 2 and the wiring layer 3 of the die 2 are formed integrally by means of connection using a bump and a conductive layer (not illustrated).

A first re-distribution layer 4 is disposed below the wiring layer 3 of the die 2. Under the first re-distribution layer 4, a plurality of external connection terminals 5 via which signals are input from and output to the outside is arranged at predetermined intervals, each external connection terminal 5 including a solder ball or the like. Then, the wiring layer 3 of the die 2 and the first re-distribution layer 4 are connected together by a plurality of vias 6.

Furthermore, the via 6 extends downward to connect to a predetermined external connection terminal 5 disposed under the first re-distribution layer 4. With such a configuration, a signal of the die 2 is electrically connected to the external connection terminal 5 via the wiring layer 3 of the die 2, the via 6, and the first re-distribution layer 4. It is therefore possible for the die 2 to input and output signals to and from the outside via the external connection terminal 5.

Furthermore, a plurality of through mold vias 7 is arranged around an outer periphery of the die 2 and an outer periphery of the wiring layer 3 of the die 2. The through mold via 7 is provided to connect the first package 10 and the second package 20. That is, the second package 20 is connected to the first package 10 via a connection terminal 29 of the second package 20 and an upper end portion 7a of the through mold via 7 connected to each other.

Furthermore, the through mold via 7 has a lower end portion 7c connected to the external connection terminal 5 via the first re-distribution layer 4.

Furthermore, some of the vias 6 bored in the re-distribution layer 3 of the die 2 have their respective lower ends connected to the lower end portion 7c of the through mold via 7 via a conductive layer 4a of the first re-distribution layer 4.

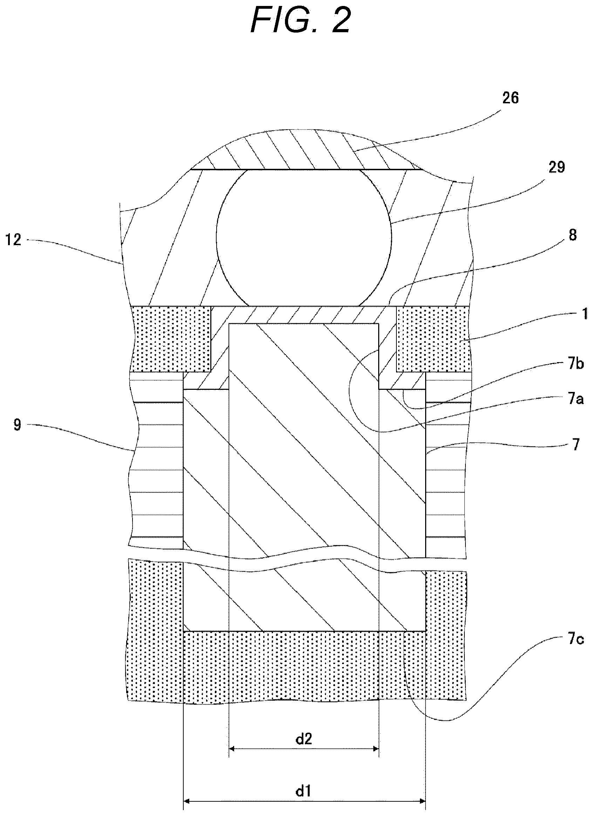

As illustrated in the enlarged cross-sectional view in Fig. 2, the through mold via 7 is a conductor including a metal such as copper having a substantially columnar shape or a substantially cylindrical shape. Then, the upper end portion 7a of the through mold via 7 is formed in a substantially columnar shape or a substantially cylindrical shape with a diameter d2 smaller than a diameter d1 of the lower end of the through mold via 7. That is, a relationship of d1 > d2 is satisfied. Note that d1 ≥ d2 may be satisfied. Furthermore, d1 < d2 may be satisfied. It is, however, desirable that d1 > d2 be satisfied.

In the example illustrated in Fig. 2, since the lower end of the through mold via 7 is formed with the diameter d1 larger than the diameter d2 of the upper end portion 7a, a step 7b is formed substantially flush with an upper surface of the die 2. That is, the step 7b is a step portion that forms a horizontal step surface parallel to the upper surface of the die 2. Then, the step 7b located at a lower end of the upper end portion 7a of the through mold via 7 is formed in an annular horizontal plane along the substantially columnar shape or the substantially cylindrical shape, and the upper end portion 7a and the step 7b have their respective peripheral surfaces entirely covered with a seed layer 8. Furthermore, the lower end portion 7c of the through mold via 7 is connected to the first re-distribution layer 4.

Furthermore, the seed layer 8 includes a metal material such as copper (Cu), titanium (Ti), tantalum (Ta), aluminum (Al), tungsten (W), nickel (Ni), ruthenium (Ru), or cobalt (Co). Then, it is formed using a physical vapor deposition method (PE-PVD) such as sputtering using plasma or a chemical vapor deposition method (PE-CVD) such as a vapor deposition method using plasma. The seed layer 8 may be formed as a single layer or may be formed as a stacked layer. Note that the seed layer 8 will be described later in detail.

As illustrated in Fig. 1, an outer peripheral space of the die 2, an outer peripheral space of the wiring layer 3 of the die 2, and an outer peripheral space of the through mold via 7 are filled with a first molding material 9. The first package 10 has the configuration as described above.

Next, an example of the second package 20 will be described. As illustrated in Fig. 1, a second die 22 is disposed on a substrate 21. Moreover, a third die 23 is disposed on the second die 22. Furthermore, the second die 22 and the third die 23 may each have a wiring layer (not illustrated) formed therein.

A plurality of electrode pads 22a and a plurality of electrode pads 23a are formed on peripheral edges of upper surfaces of the second die 22 and the third die 23, respectively. Furthermore, a plurality of substrate pads 24 is arranged on the substrate 21 adjacent to an outer periphery of the second die 22 and an outer periphery of the third die 23. The substrate pad 24 may be a pad including a wiring layer. Then, the electrode pads 22a and 23a are each connected to the substrate pad 24 by a bonding wire 25 such as a gold wire. Then, an outer peripheral space of the second die 22, an outer peripheral space of the third die 23, and an outer peripheral space of the bonding wire 25, the second die 22, the third die 23, and the bonding wire 25 being disposed on the substrate 21, are filled with a second molding material 28.

The substrate 21 has a copper wiring 26 disposed at its lower side. Then, a through via 27 is bored in the substrate 21, and the through via 27 electrically connects the substrate pad 24 located on an upper surface of the substrate 21 and the copper wiring 26 located on a lower surface of the substrate 21. With this configuration, an input/output signal of the second die 22 is connected to the copper wiring 26 and the connection terminal 29 disposed on a lower surface of the second package 20 via the electrode pad 22a, the bonding wire 25, the substrate pad 24, and the through via 27. Similarly, an input/output signal of the third die 23 is connected to the copper wiring 26 and the connection terminal 29 disposed on the lower surface of the second package 20 via the electrode pad 23a, the bonding wire 25, the substrate pad 24, and the through via 27.

In the first package 10 and the second package 20 configured as described above, the upper end portion 7a of the through mold via 7 of the first package 10 and the connection terminal 29 of the copper wiring 26 of the second package 20 are arranged to face each other and are joined via the seed layer 8.

The upper end portion 7a of the first package 10 and the connection terminal 29 of the second package 20 are joined as described above, so that the first package 10 and the second package 20 are electrically connected.

An outer periphery of the connection terminal 29 is filled with an underfill 12. Note that the underfill 12 is a liquid curable resin. In general, an integrated circuit mounted on a substrate or the like is very vulnerable to external force or stress, and is easily broken by slight external force. Furthermore, it is also vulnerable to temperature and humidity, and may be subject to corrosion or the like with no measure taken. As a measure against such problems, the underfill 12 is used.

The configuration of the first embodiment according to the present disclosure is as described above.

### <2. Method for manufacturing first embodiment of semiconductor device according to present disclosure>

Next, a method for manufacturing the first embodiment of the semiconductor device 100 according to the present disclosure will be described.

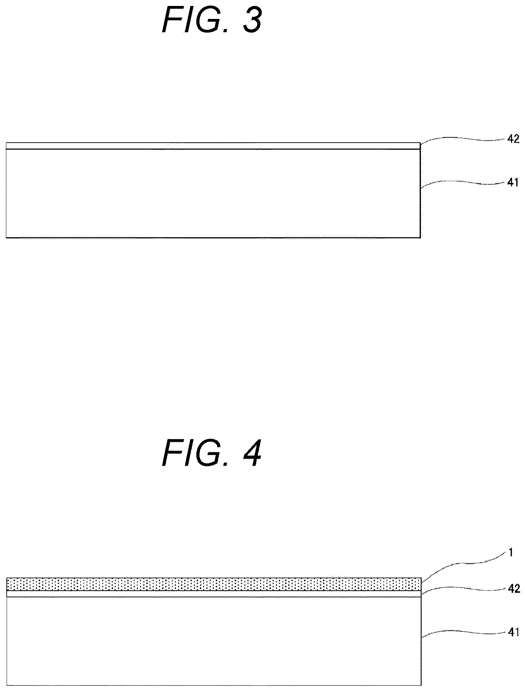

Figs. 3 to 15 are process explanatory diagrams of the method for manufacturing the first embodiment of the semiconductor device 100 according to the present disclosure.

First, as illustrated in Fig. 3, an adhesive 42 is deposited on a support substrate 41. The support substrate 41 and the adhesive 42 are used for so-called temporary joining, and are removed in a subsequent process. As the adhesive 42, a material that can be stripped off by UV irradiation or mechanical stress is used. The adhesive 42 is deposited by a coating method or lamination. As the support substrate 41, a silicon (Si) substrate or a glass substrate is used in a manner that depends on the type of the adhesive 42.

Next, as illustrated in Fig. 4, the protective film 1 is formed on the adhesive 42. The protective film 1 may be a resin material having polyimide, acrylic, epoxy, or the like as a skeleton, or may be an inorganic material such as silicon dioxide (SiO₂) or silicon nitride (Si₃N₄). The thickness is preferably about 1 to 50 µm. The protective film 1 serves as a base on which a package of the semiconductor device 100 according to the present disclosure is made.

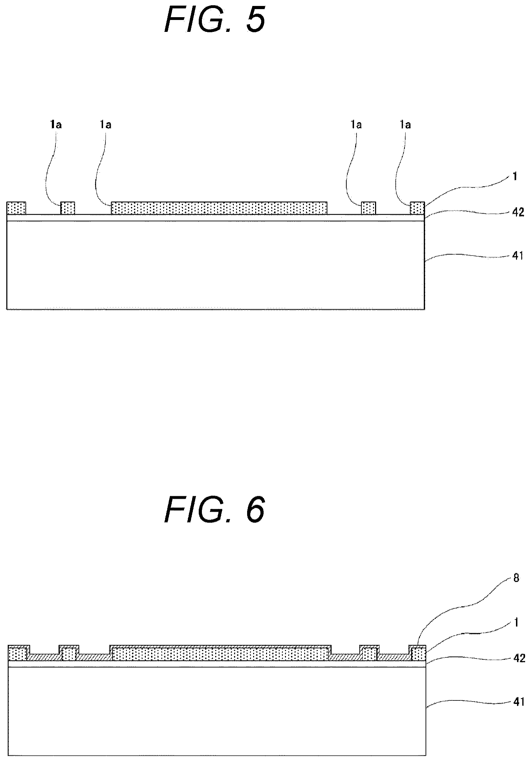

Next, as illustrated in Fig. 5, the protective film 1 is patterned to form a protective film opening 1a at which the through mold via 7 is to be formed. The protective film opening 1a serves as a mold for forming the upper end portion 7a of the through mold via 7. Here, in a case where a photosensitive material is used for the protective film 1, the patterning may be performed by lithography. Furthermore, the patterning may be performed by dry etching using a resist mask. In this case, a diameter of the opening is preferably about 3 to 100 µm.

Next, as illustrated in Fig. 6, the seed layer 8 including a conductive material is formed. The seed layer 8 includes a metal material such as copper (Cu), titanium (Ti), tantalum (Ta), aluminum (Al), tungsten (W), nickel (Ni), ruthenium (Ru), or cobalt (Co), and is formed by a physical vapor deposition method (PE-PVD) such as sputtering or a chemical vapor deposition method (PE-CVD) such as a vapor deposition method. The seed layer 8 may be formed as a single layer or may be formed as a stacked layer.

The reason for forming the seed layer 8 on an upper surface of the protective film 1 is as follows. That is, the protective film 1 is an insulator, so that the through mold via 7 having conductivity cannot be formed on the protective film 1 by plating as it is. Therefore, forming the seed layer 8 having conductivity on the surface of the protective film 1 allows the through mold via 7 to be formed.

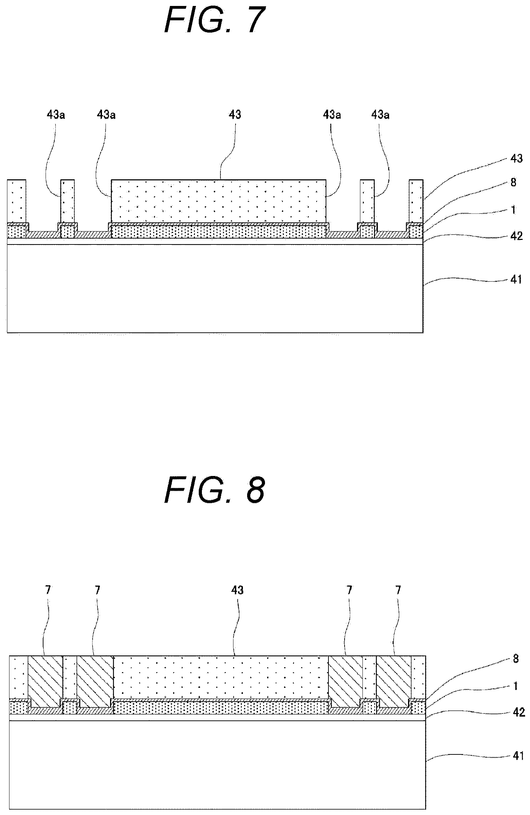

Next, as illustrated in Fig. 7, a resist mask 43 is applied to an upper surface of the seed layer 8. Then, a resist opening 43a for forming the through mold via 7 is formed in the resist mask 43 by lithography according to a shape of the through mold via 7. Here, the resist opening 43a is formed with an opening diameter larger than a diameter of the protective film opening 1a. Such formation allows the diameter d1 of the lower end of the through mold via 7 and the diameter d2 of the upper end portion 7a of the mold through via 7 to satisfy the relationship of d1 > d2. Then, when the through mold via 7 is formed, the step 7b having a width of (d1 - d2)/2 is formed.

Next, as illustrated in Fig. 8, the through mold via 7 is formed in the resist opening 43a of the resist mask 43. As a method for forming the through mold via 7, a plating method or the like is used. As a material of plating, copper (Cu), nickel (Ni), platinum (Pt), palladium (Pd), aluminum (Al), or a solder material is used.

Furthermore, the seed layer 8 is formed on an inner peripheral surface of the resist opening 43a including a bottom of the resist opening 43a and all over the upper surface of the protective film 1. Therefore, the upper end portion 7a and the step 7b of the through mold via 7 have their respective peripheral surfaces entirely covered with the seed layer 8. Therefore, since the seed layer 8 is formed all over the peripheral surfaces of the upper end portion 7a and the step 7b of the through mold via 7, a contact area between the through mold via 7 and the protective film 1 can be increased. It is therefore possible to improve adhesion between the protective film 1 and the through mold via 7, and it is also possible to prevent collapse or misalignment. Furthermore, even when stress generated by temperature change, mechanical external force, or the like is applied, separation is less likely to occur. As a result, it is possible to reduce the occurrence of defects such as a break in a wiring of an electric circuit, and it is possible to significantly increase quality and reliability.

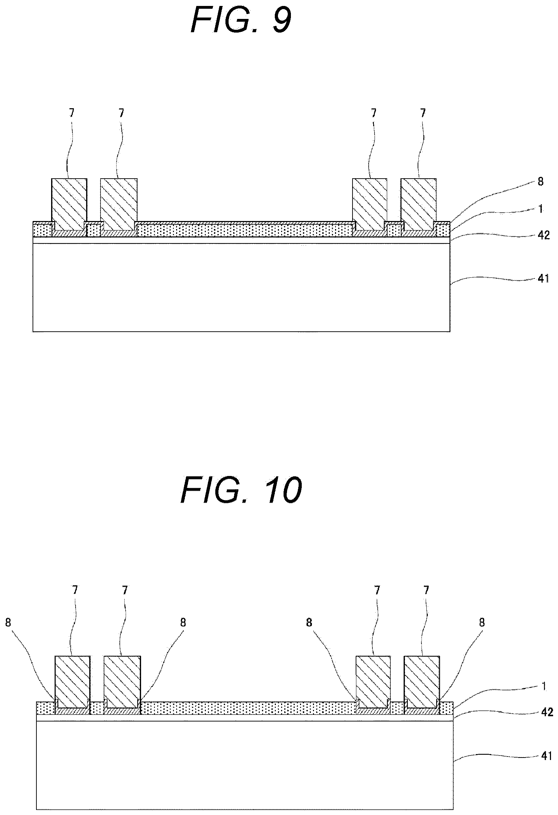

Next, as illustrated in Fig. 9, the resist mask 43 is removed. As a result, the through mold via 7 is exposed in an erect state. In this case, as described above, the through mold via 7 has the upper end portion 7a and the step 7b fitted to the protective film 1 via the seed layer 8, so that the through mold via 7 is less prone to collapse or separation.

Next, as illustrated in Fig. 10, the seed layer 8 is removed by wet etching. As a result, the surface of the protective film 1 is exposed as an insulating layer.

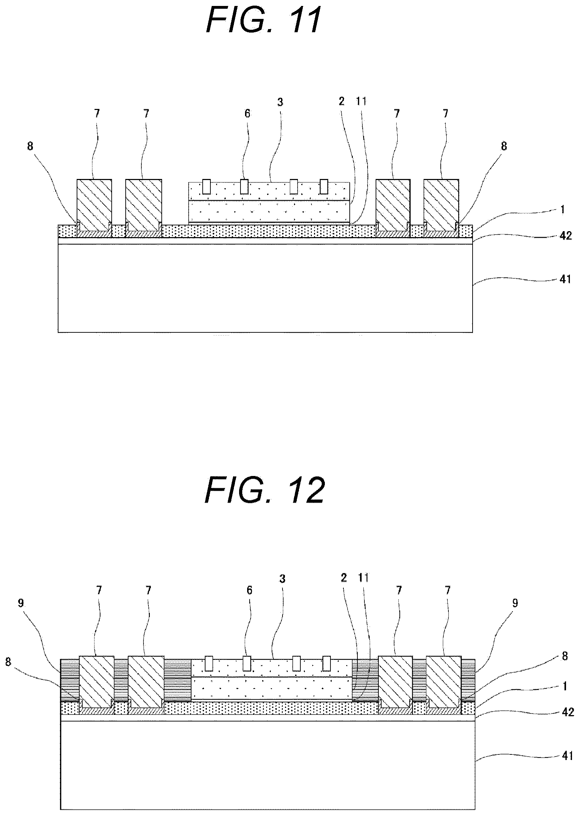

Next, as illustrated in Fig. 11, an adhesive 11 is applied to a back surface of the die 2 integrated with the wiring layer 3 to bond the die 2 integrated with the wiring layer 3 to a predetermined position on a side of the protective film 1 where the through mold via 7 is erect. The die 2 is a chip of an integrated circuit, and may be of a type such as a logic element, a memory element, or an element of a control circuit such as a microcomputer. Furthermore, a plurality of them may be arranged.

Next, as illustrated in Fig. 12, the die 2, the wiring layer 3 of the die 2, and the through mold via 7 have their respective outer peripheral spaces filled with the first molding material 9. After the filling with the first molding material 9, the upper surface of the through mold via 7 and the upper surface of the die 2 are cut off to make an opening corresponding to a conductive portion. The opening is desirably formed such that, once it is formed thicker than the through mold via 7 and the die 2, the through mold via 7 and the via 6 of the wiring layer 3 are opened while the surface is planarized by a grinder, chemical mechanical polisher (CMP), or the like.

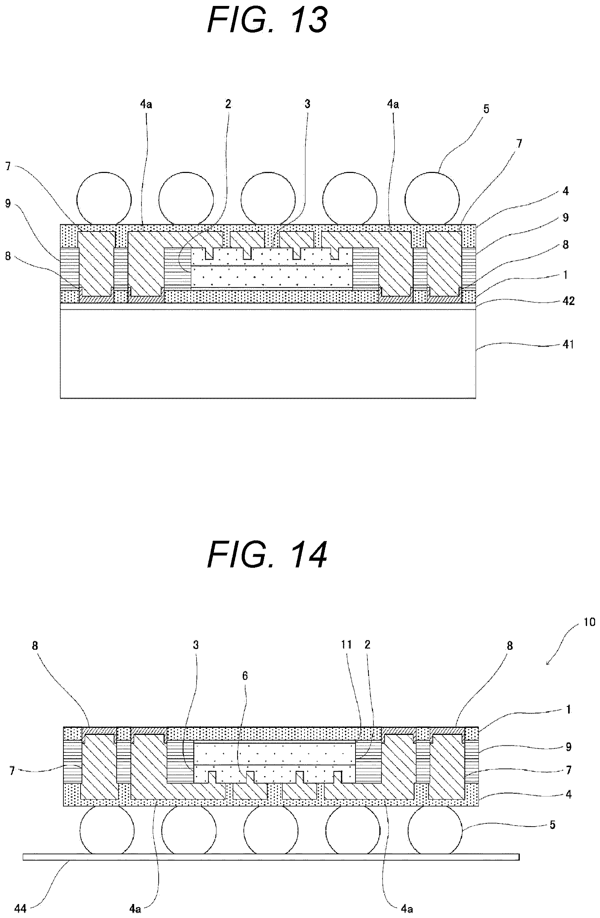

Next, as illustrated in Fig. 13, the first re-distribution layer 4 is formed. As an insulating film of the first re-distribution layer 4, in a case of an inorganic film, silicon dioxide (SiO₂), silicon oxynitride (SiON), silicon nitride (Si₃N₄), or silicon oxycarbide (SiOC) is used. Furthermore, in a case of an organic film, a resin film having silicone, polyimide, acrylic, epoxy, or the like as a skeleton is used.

Furthermore, the conductive layer 4a includes a metal material such as copper (Cu), titanium (Ti), tantalum (Ta), aluminum (Al), tungsten (W), nickel (Ni), ruthenium (Ru), or cobalt (Co).

This drawing illustrates an example where the conductive layer 4a as a single layer is connected to and integrated with the lower end portion 7c of the through mold via 7, but the conductive layer 4a is not limited to such a single layer, and may be a multilayer wiring. After the first re-distribution layer 4 is formed, the external connection terminal 5 such as a solder ball or a conductive pillar is formed on the first re-distribution layer 4.

Next, as illustrated in Fig. 14, the external connection terminal 5 is covered with a protective tape 44, and the first package 10 is turned upside down. Then, the support substrate 41 and the adhesive 42 that are temporarily joined are removed. In this state, however, the first package 10 is thin and is thus in an unstable state, so that it is difficult to perform a highly accurate process. With the structure of the semiconductor device 100 according to the present disclosure, however, the through mold via 7 electrically insulated in advance and penetrating the protective film 1 is formed, so that the removal of the adhesive 42 exposes a top surface of the upper end portion 7a of the through mold via 7. This brings about a state where connection with the second package 20 is possible.

Therefore, the semiconductor device 100 according to the present disclosure eliminates the need of performing a highly accurate process such as polishing to expose an end surface of the upper end portion 7a of the through mold via 7 in such an unstable state as in the related art. It is therefore possible to increase the yield and perform stable manufacturing.

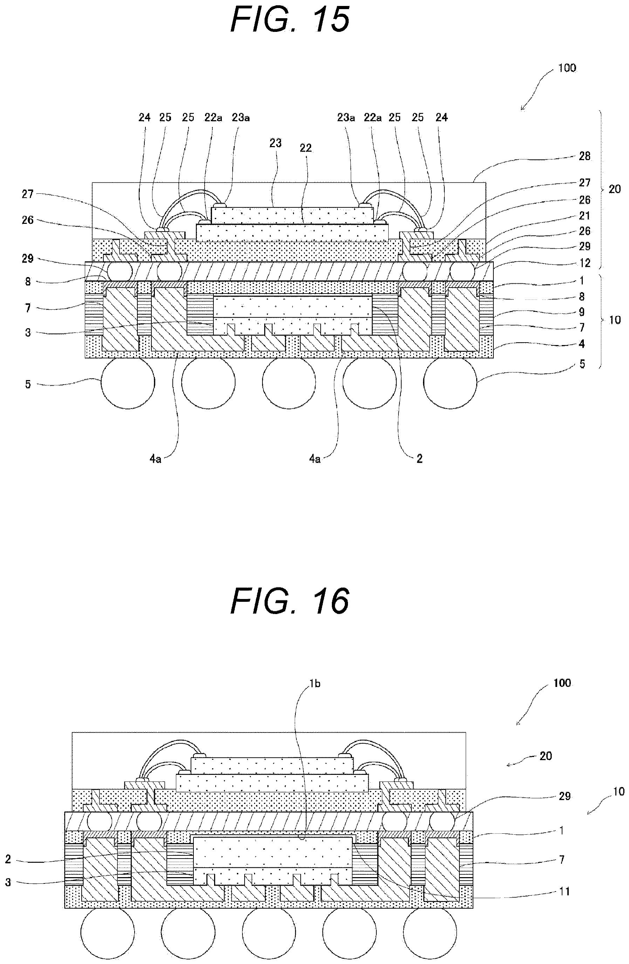

Next, as illustrated in Fig. 15, the connection terminal 29 of the second package 20 is placed to face the through mold via 7 on an upper surface of the first package 10, and the through mold via 7 and the connection terminal 29 are joined and connected by means of the application of a mechanical load or the like. This drawing illustrates, as the second package 20, a structure in which two dies, a second die 22 and a third die 23, are placed on the protective film 1 of the first package 10.

The second package 20 can be formed by the following processes. First, at least one die is bonded onto the substrate 21. For example, as illustrated in Fig. 15, the second die 22 and the third die 23 are bonded onto the substrate 21. Next, the plurality of electrode pads 22a and the plurality of electrode pads 23a formed on the peripheral edges of the upper surfaces of the second die 22 and the third die 23, respectively, are each connected to a corresponding one of the plurality of substrate pads 24 arranged on the substrate 21 by the bonding wire 25 such as a gold wire. Next, the second die 22, the third die 23, and the bonding wire 25 on the substrate 21 have their respective outer peripheral spaces filled with the second molding material 28.

Note that the number of dies mounted on and bonded to the substrate 21 is not limited to two, and any desired number of dies may be mounted. Furthermore, the type of die is not limited to any specific type.

Furthermore, the semiconductor device 100 according to the present disclosure is not limited to such a structure, and may have, for example, a wafer level chip size package (WLCSP) structure of the protective film 1 using no resin. Furthermore, the underfill 12 that is a liquid curable resin may fill a space between the first package 10 and the second package 20.

### <3. Second embodiment of semiconductor device according to present disclosure and method for manufacturing the same>

Next, a second embodiment of the semiconductor device 100 according to the present disclosure and a method for manufacturing the same will be described. Fig. 16 is a schematic cross-sectional view of the second embodiment of the semiconductor device 100 according to the present disclosure.

The present embodiment is different from the first embodiment in that a recess 1b is formed at a portion of the protective film 1 where the die 2 of the integrated circuit comes into contact with so as to make the contact portion thinner than the other portion, as compared with the structure of the first embodiment.

The predetermined portion of the protective film 1 can be made thinner as described above by adding, to the above-described process in Fig. 5, a process of forming the recess 1b having a predetermined depth in the surface with which the die 2 comes into contact as illustrated in Fig. 16. With this configuration, a peripheral side surface of the die 2 can be fixed in the recess 1b of the protective film 1, and the thickness of the packages 10 and 20 can be reduced by the depth of the recess 1b. Furthermore, it is possible to reduce die shift during the manufacturing process.

Here, the die shift refers to a phenomenon in which, when a die is encapsulated in a molding resin, and curing (hardening) is made, the mold resin contracts, and the die moves accordingly.

Furthermore, in order to fix the die 2 of the integrated circuit, the recess 1b of the protective film 1 may be further deepened to form a through hole. With such a configuration, the die 2 is fitted into the through hole, and the peripheral side surface of the die 2 is more firmly fixed by the protective film 1 in a similar manner as described above. Furthermore, it is possible to reduce die shift during the manufacturing process. Furthermore, since the die 2 is fitted into the protective film 1, the thickness of the packages 10 and 20 can be reduced. Moreover, a portion of the protective film 1 where the die 2 is disposed and that serves as a base of the packages 10 and 20 is disposed at substantially a center in the thickness direction of the packages 10 and 20, and the die 2 is disposed at substantially a center of the protective film 1 as viewed from above. With this configuration, moment of force received by the upper surface of the protective film 1 and moment of force received by the lower surface of the protective film 1 are balanced, and stress received by the die 2 can be reduced accordingly. Therefore, warpage of the die 2 can also be reduced.

### <4. Third embodiment of semiconductor device according to present disclosure and method for manufacturing the same>

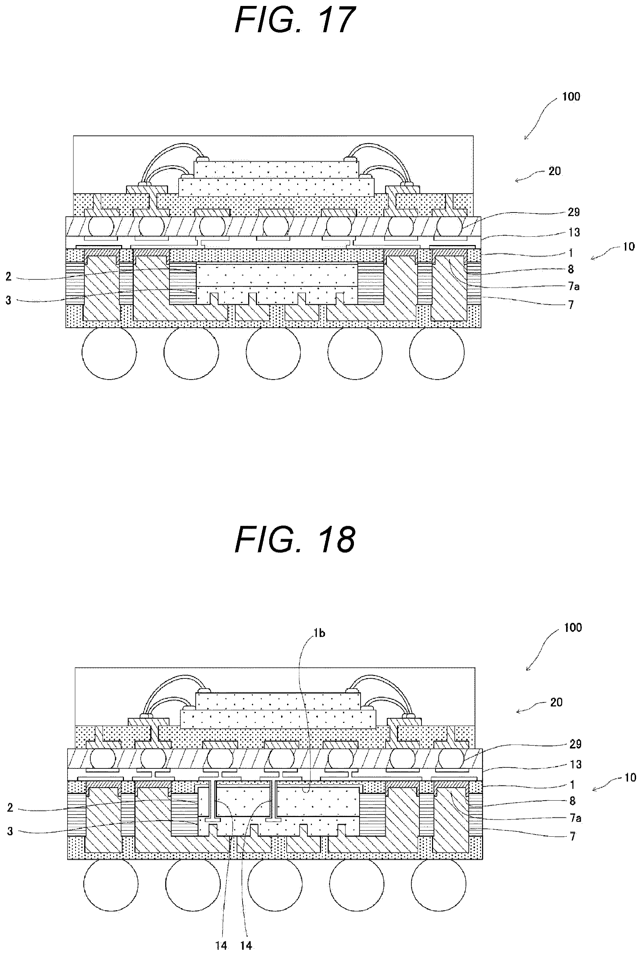

Next, a third embodiment of the semiconductor device 100 according to the present disclosure and a method for manufacturing the same will be described. Fig. 17 is a schematic cross-sectional view of the third embodiment of the semiconductor device 100 according to the present disclosure.

The present embodiment is different from the first embodiment in that a second re-distribution layer 13 is formed on the protective film 1, as compared with the structure of the first embodiment. The present embodiment can be implemented by adding a process of forming the second re-distribution layer 13 between the processes in Fig. 3 and Fig. 4 of the method for manufacturing the first embodiment.

That is, the second re-distribution layer 13 is formed before the protective film 1 is formed. Specifically, as illustrated in Fig. 3, the adhesive 42 is applied to the support substrate 41. Next, the second re-distribution layer 13 illustrated in Fig. 17 is formed on an upper surface of the adhesive 42. Then, the protective film 1 as illustrated in Fig. 4 is formed on an upper surface of the second re-distribution layer 13. The following processes are similar to the processes in Fig. 5 and the subsequent drawings of the method for manufacturing the first embodiment.

As an insulating film of the second re-distribution layer 13, a resin film having silicon dioxide (SiO₂), silicon oxynitride (SiON), silicon nitride (Si₃N₄), or silicon oxycarbide (SiOC) as a skeleton is used in a case of an inorganic film, or a resin film having silicone, polyimide, acrylic, epoxy, or the like as a skeleton is used in a case of an organic film. Furthermore, a conductive layer 13a includes a metal material such as copper (Cu), titanium (Ti), tantalum (Ta), aluminum (Al), tungsten (W), nickel (Ni), ruthenium (Ru), or cobalt (Co).

With such a structure, a region above the die 2 of the integrated circuit can also be used for electrical connection with the second package 20, so that a limited package space can be effectively used. It is therefore possible to downsize the package.

### <5. Fourth embodiment of semiconductor device according to present disclosure and method for manufacturing the same>

Next, a fourth embodiment of the semiconductor device 100 according to the present disclosure and a method for manufacturing the same will be described. Fig. 18 is a schematic cross-sectional view of the fourth embodiment of the semiconductor device 100 according to the present disclosure.

The present embodiment is different from the first embodiment in that the second re-distribution layer 13 is formed, and a through electrode 14 extending from the second re-distribution layer 13 to connect to the wiring layer 3 of the die 2 of the integrated circuit is formed, as compared with the structure of the first embodiment.

The present embodiment can be implemented by adding, with the second re-distribution layer 13 formed in advance, a process of forming the through electrode 14 between the processes in Fig. 14 and Fig. 15 of the method for manufacturing the first embodiment. For example, between the processes in Figs. 14 and 15, after the support substrate 41 and the adhesive 42 are removed, the through electrode 14 may be bored in the protective film 1. In this case, first, as described with reference to Fig. 16, the recess 1b is formed in the protective film 1, or the recess 1b is deepened to form a through hole into which the die 2 can be fitted, and the die 2 integrated with the wiring layer 3 in the process illustrated in Fig. 11 is bonded to or fitted into the through hole. Then, between the processes in Figs. 14 and 15, the through electrode 14 is bored from the second re-distribution layer 13 toward the die 2. With such a configuration, it is possible to make the boring distance shorter. Furthermore, the configuration facilitates the formation of the through electrode 14.

In this case, in the process illustrated in Fig. 11, with the die 2 integrated with the wiring layer 3 in which the through electrode 14 is bored bonded to the protective film 1 in advance, the through electrode 14 extending from the second re-distribution layer 13 to the wiring layer 3 of the die 2 may be bored.

Furthermore, the through electrode 14 can be formed even in a state where the second re-distribution layer 13 is not formed. For example, as described above, first, the recess 1b of the protective film 1 is deepened to form a through hole, and the die 2 is fitted into the through hole of the protective film 1. In this case, it is assumed that a bump having a copper wiring on the upper surface of the die 2 is exposed. Then, after the process illustrated in Fig. 14, the through electrode 14 extending from the copper wiring of the bump formed on the upper surface of the die 2 to the wiring layer 3 of the die 2 is bored. Then, the bump connected to the through electrode 14 via the copper wiring may be directly connected to the connection terminal 29 of the second package. This configuration eliminates the need of the process of forming the second re-distribution layer 13, and the number of processes can be reduced accordingly.

With such a structure, regions above and below the die 2 can also be used for electrical connection with the second package 20, and a signal path connected to the die 2 can be increased. It is therefore possible to use a limited package space effectively, and it is thus possible to downsize the packages 10 and 20.

### <6. Fifth embodiment of semiconductor device according to present disclosure and method for manufacturing the same>

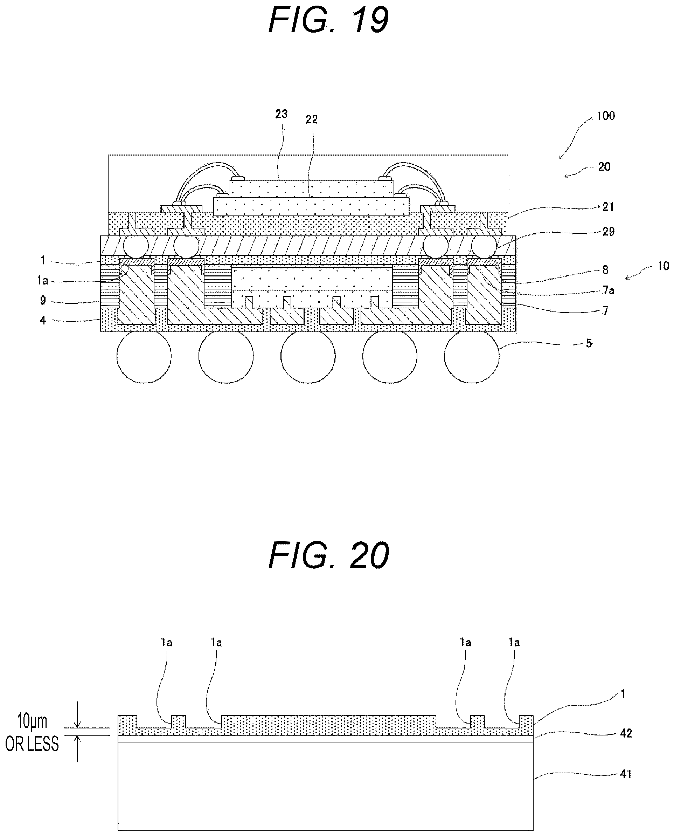

Next, a fifth embodiment of the semiconductor device 100 according to the present disclosure and a method for manufacturing the same will be described. Fig. 19 is a schematic cross-sectional view of the fifth embodiment of the semiconductor device 100 according to the present disclosure.

The present embodiment is different from the first embodiment in that the upper end portion 7a of the through mold via 7 is connected to the connection terminal 29 of the second package 20 via the seed layer 8 at the middle of the protective film 1 in the thickness direction without the upper end portion 7a opened to the upper surface of the protective film 1, as compared with the structure of the first embodiment.

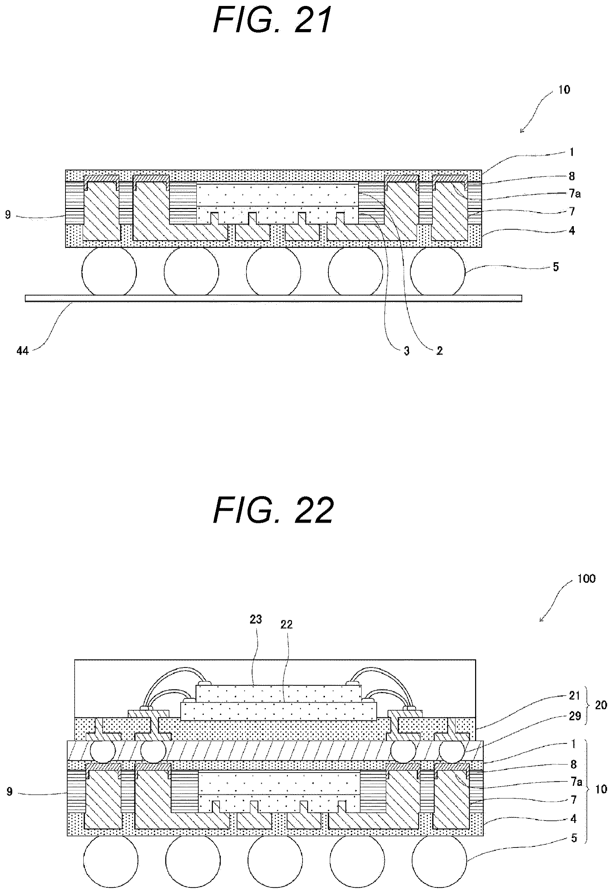

Figs. 20 to 22 illustrate processes representing the difference between the method for manufacturing the present embodiment and the method for manufacturing the first embodiment. A process illustrated in Fig. 20 corresponds to the process illustrated in Fig. 5 of the first embodiment. That is, in the first embodiment, the protective film opening 1a of the protective film 1 is formed as a through hole, but in the present embodiment, the protective film opening 1a is bored to the middle of the protective film 1 in the thickness direction to form a residual film. The subsequent processes are similar to the processes of the first embodiment except for the following processes in Figs. 21 and 22. The residual film of the protective film 1 in the protective film opening 1a is desirably less than or equal to 10 µm.

The process illustrated in Fig. 21 corresponds to the process illustrated in Fig. 14 of the first embodiment. That is, the first package 10 is completed at this point. The upper end portion 7a of the through mold via 7, however, is not exposed due to the presence of the residual film of the protective film 1. Therefore, the upper end portion 7a is not in an electrically connectable state.

Therefore, as illustrated in Fig. 22, the second package 20 is placed on the first package 10 with the upper end portion 7a of the through mold via 7 of the first package 10 and the connection terminal 29 of the second package 20 facing each other. At the time of the placement, the upper end portion 7a and the connection terminal 29 are aligned. Next, mechanical stress such as a load is applied to bond the upper end portion 7a and the connection terminal 29, and the mechanical stress is further applied to establish electrical connection between the upper end portion 7a and the connection terminal 29.

Furthermore, for example, with heat at a temperature of about 150 to 260°C applied, mechanical stress such as a load is applied to cause the connection terminal 29 to break the residual film of the protective film 1 present at the upper end portion 7a of the through mold via 7 to establish electrical connection between the upper end portion 7a and the connection terminal 29. In this case, the shape of the connection terminal 29 need not necessarily be a spherical shape as illustrated in Fig. 22, and may be a substantially conical shape or a spindle-like shape with a pointed tip, or a shape having a plurality of protrusions at a tip.

As described above, it is possible to establish electrical connection between the upper end portion 7a and the connection terminal 29 by the application of heat and the application of mechanical stress such as a load. This eliminates the need of the process of grinding or chemical mechanical polishing for exposing the upper end portion 7a of the through mold via 7, and it is therefore possible to eliminate a highly accurate process.

### <7. Electronic device including semiconductor device according to present disclosure>

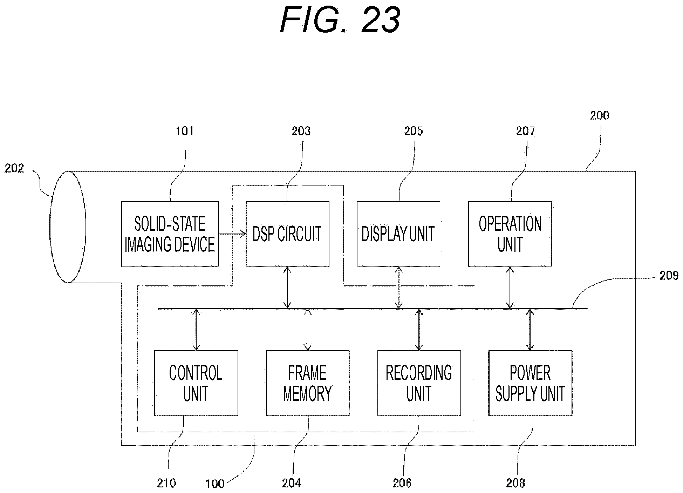

A configuration example of an electronic device including the semiconductor device 100 according to the first to fifth embodiments described above will be described with reference to Fig. 23.

The semiconductor device 100 according to the present disclosure can be applied to an imaging device such as a digital still camera or a video camera using a solid-state imaging device 101, a mobile terminal device having an imaging function, or an imaging apparatus such as a copying machine using the solid-state imaging device 101 as an image reading unit. Furthermore, the semiconductor device 100 is applied not only to such imaging apparatuses, but also to a wide variety of electronic devices such as industrial apparatuses, communication apparatuses, and in-vehicle apparatuses including household electric apparatuses.

Here, an imaging device 200 used together with the solid-state imaging device 101 will be described as an example of an electronic device using the semiconductor device 100 according to the present disclosure. The solid-state imaging device 101 may be a CMOS sensor or a CCD sensor. Furthermore, as the semiconductor device 100, a control unit 210 that performs overall control of the imaging device 200 including control of a DSP circuit 203, a frame memory 204, a display unit 205, or an operation unit 207, which will be described later, constituting the imaging device 200, and the like may be packaged.

As illustrated in Fig. 23, the imaging device 200 as an electronic device includes an optical unit 202, the solid-state imaging device 101, the digital signal processor (DSP) circuit 203 which is a camera signal processing circuit, the frame memory 204, the display unit 205, a recording unit 206, the operation unit 207, the control unit 210, and a power supply unit 208. The DSP circuit 203, the frame memory 204, the display unit 205, the recording unit 206, the operation unit 207, the control unit 210, and the power supply unit 208 are connected to each other through a bus line 209.

The optical unit 202 includes a plurality of lenses, and captures incident light (image light) from a subject to form an image on a light receiving unit (not illustrated) of the solid-state imaging device 101. The solid-state imaging device 101 converts a light amount of the incident light imaged on the light receiving unit by the optical unit 202 into an electrical signal in units of pixels and outputs the electrical signal as a pixel signal.

The display unit 205 including a panel display device such as a liquid crystal panel and an organic electro luminescence (EL) panel, for example, displays a moving image or a still image captured by the solid-state imaging device 101. The recording unit 206 records the moving image or the still image captured by the solid-state imaging device 101 on a recording medium such as a hard disk or a semiconductor memory.

The operation unit 207 issues operation commands for various functions of the imaging device 200 under operation by a user. The control unit 210 outputs a control signal to each of the DSP circuit 203, the frame memory 204, the display unit 205, the recording unit 206, and the operation unit 207 to control the entire imaging device 200. The power supply unit 208 appropriately supplies various power sources serving as operation power sources of the DSP circuit 203, the frame memory 204, the display unit 205, the recording unit 206, the operation unit 207, and the control unit 210 to supply targets.

As described above, with the semiconductor device 100 according to the present disclosure, the control unit 210 of the DSP circuit 203, the frame memory 204, the display unit 205, and the like constituting the imaging device 200, and the like can be packaged, so that necessary circuits can be densely integrated. It is therefore possible to provide the imaging device 200 including the semiconductor device 100 according to the present disclosure in a small size and at a low cost.

Finally, the description of each of the above-described embodiments is an example of the present disclosure, and the present disclosure is not limited to the above-described embodiments. For this reason, it is needless to say that various modifications other than the above-described embodiments can be made according to the design and the like without departing from the technical idea according to the present disclosure. Furthermore, the effects described in the present specification are merely examples and are not limited, and other effects may be provided.

Note that the present technology can adopt the following configurations.
(1) A semiconductor device including:
   a first package including
   a die of an integrated circuit,
   a protective film disposed on an upper surface of the die, the protective film being larger in area than the die,
   a first molding material covering an outer periphery of the die,
   a plurality of through mold vias formed penetrating the first molding material and the protective film, the plurality of through mold vias being smaller in penetrating diameter of the protective film than the first molding material,
   a seed layer formed on upper end portions of the through mold vias and peripheral side surfaces of the through mold vias, and
   an external connection terminal connected to lower end portions of the through mold vias; and
   a second package placed on an upper surface of the protective film of the first package and connected to the upper end portions of the through mold vias.
(2) The semiconductor device according to the above (1), in which the protective film disposed on the upper surface of the die is formed such that a surface with which the die comes into contact is thinner.
(3) The semiconductor device according to the above (1), in which the protective film disposed on the upper surface of the die is formed such that a surface with which the die comes into contact is a through hole into which the die can be fitted.
(4) The semiconductor device according to any one of the above (1) to (3), in which at least one second re-distribution layer that is connected to the through mold vias is formed on the upper surface of the protective film.
(5) The semiconductor device according to the above (4), in which a connection terminal of the second package is formed on the second re-distribution layer.
(6) The semiconductor device according to any one of the above (1) to (4), in which a through electrode that penetrates the die to connect to a wiring layer of the die is bored.
(7) The semiconductor device according to any one of the above (1) to (4), in which the through mold vias and the connection terminal of the second package are connected in the protective film.
(8) The semiconductor device according to any one of the above (1) to (4), in which the external connection terminal is formed connecting to the lower end portions of the through mold vias via a first re-distribution layer.
(9) A method for manufacturing a semiconductor device, the method including:
   a process of forming a protective film and forming a through mold via in the protective film;
   a process of bonding, after the through mold via is formed, a die of an integrated circuit to a surface of the protective film in which the through mold via is formed to form a first package on a surface side where the die is bonded; and
   a process of forming a second package on a surface side of the first package where the die is not bonded.
(10) The method for manufacturing a semiconductor device according to the above (9), in which the process of forming a protective film and forming a through mold via in the protective film includes:
   a process of applying an adhesive to a support substrate;
   a process of forming the protective film on an upper surface of the adhesive;
   a process of patterning the protective film according to a planar shape of an upper end portion of the through mold via and a planar shape of the die;
   a process of forming a seed layer on an upper surface of the protective film that has been patterned; and
   a process of forming a resist mask on an upper surface of the seed layer according to a shape of a lower end portion of the through mold via.
(11) The method for manufacturing a semiconductor device according to the above (9) or (10), in which the process of forming a protective film and forming a through mold via in the protective film includes:
   a process of applying an adhesive to a support substrate;
   a process of forming a second re-distribution layer on an upper surface of the adhesive;
   a process of forming the protective film on an upper surface of the second re-distribution layer;
   a process of patterning the protective film;
   a process of forming a seed layer on an upper surface of the protective film that has been patterned; and
   a process of forming a resist mask on an upper surface of the seed layer according to a shape of the through mold via.
(12) The method for manufacturing a semiconductor device according to any one of the above (9) to (11), in which the process of bonding, after the through mold via is formed, a die of an integrated circuit to a surface of the protective film in which the through mold via is formed to form a first package on a surface side where the die is bonded includes:
   a process of forming the through mold via on the protective film;
   a process of bonding the die to a surface on which the through mold via is formed;
   a process of forming a through electrode penetrating and connecting the die and the wiring layer of the die;
   a process of filling an outer periphery of the through mold via and an outer periphery of the die with a first molding material; and
   a process of forming a first re-distribution layer on a surface side where the die is not bonded.
(13) The method for manufacturing a semiconductor device according to any one of the above (9) to (12), in which the process of forming a second package on a surface side of the first package where the die is not bonded includes:
   a process of bonding at least one another die onto a substrate and connecting a pad of the another die and a pad of the substrate;
   a process of filling an outer periphery of the another die with a second molding material;
   a process of forming a connection terminal on a surface side of the substrate where the another die is not bonded; and
   a process of connecting the connection terminal formed in the second package and the upper end portion of the through mold via formed in the first package.
(14) The method for manufacturing a semiconductor device according to the above (13), in which the process of connecting the connection terminal formed in the second package and the upper end portion of the through mold via formed in the first package includes:
   a process of placing the second package on the first package;
   a process of joining the upper end portion of the through mold via formed in the first package and the connection terminal formed in the second package together with the upper end portion of the through mold via and the connection terminal facing each other; and
   a process of establishing connection by mechanical stress or mechanical stress and heating in the joined state.
(15) An electronic device including a semiconductor device, the semiconductor device including:
   a first package including
   a die of an integrated circuit,
   a protective film disposed on an upper surface of the die, the protective film being larger in area than the die,
   a first molding material covering an outer periphery of the die,
   a plurality of through mold vias formed penetrating the first molding material and the protective film, the plurality of through mold vias being smaller in penetrating diameter of the protective film than the first molding material,
   a seed layer formed on upper end portions of the through mold vias and peripheral side surfaces of the through mold vias, and
   an external connection terminal connected to lower end portions of the through mold vias; and
   a second package placed on an upper surface of the protective film of the first package and connected to the upper end portions of the through mold vias.

### REFERENCE SIGNS LIST

- 1: Protective film
- 1a: Protective film opening
- 1b: Recess
- 2: Die
- 3: Wiring layer of die
- 4: First re-distribution layer
- 4a: Conductive layer
- 5: External connection terminal
- 6: Via
- 7: Through mold via
- 7a: Upper end portion
- 7b: Step
- 7c: Lower end portion
- 8: Seed layer
- 9: First molding material
- 10: First package
- 11: Adhesive
- 12: Underfill
- 13: Second re-distribution layer
- 13a: Conductive layer
- 14: Through electrode
- 20: Second package
- 21: Substrate
- 22: Second die
- 22a: Electrode pad
- 23: Third die
- 23a: Electrode pad
- 24: Substrate pad
- 25: Bonding wire
- 26: Copper wiring
- 27: Through via
- 28: Second molding material
- 29: Connection terminal
- 41: Support substrate
- 42: Adhesive
- 43: Resist mask
- 43a: Resist opening
- 44: Protective tape
- 100: Semiconductor device
- 101: Solid-state imaging device
- 200: Imaging device

## Claims

1. A semiconductor device comprising:
a first package including
a die of an integrated circuit,
a protective film disposed on an upper surface of the die, the protective film being larger in area than the die,
a first molding material covering an outer periphery of the die,
a plurality of through mold vias formed penetrating the first molding material and the protective film, the plurality of through mold vias being smaller in penetrating diameter of the protective film than the first molding material,
a seed layer formed on upper end portions of the through mold vias and peripheral side surfaces of the through mold vias, and
an external connection terminal connected to lower end portions of the through mold vias; and
a second package placed on an upper surface of the protective film of the first package and connected to the upper end portions of the through mold vias.

2. The semiconductor device according to claim 1, wherein the protective film disposed on the upper surface of the die is formed such that a surface with which the die comes into contact is thinner.

3. The semiconductor device according to claim 1, wherein the protective film disposed on the upper surface of the die is formed such that a surface with which the die comes into contact is a through hole into which the die can be fitted.

4. The semiconductor device according to claim 1, wherein at least one second re-distribution layer that is connected to the through mold vias is formed on the upper surface of the protective film.

5. The semiconductor device according to claim 4, wherein a connection terminal of the second package is formed on the second re-distribution layer.

6. The semiconductor device according to claim 1, wherein a through electrode that penetrates the die to connect to a wiring layer of the die is bored.

7. The semiconductor device according to claim 1, wherein the through mold vias and the connection terminal of the second package are connected in the protective film.

8. The semiconductor device according to claim 1, wherein the external connection terminal is formed connecting to the lower end portions of the through mold vias via a first re-distribution layer.

9. A method for manufacturing a semiconductor device, the method comprising:
a process of forming a protective film and forming a through mold via in the protective film;
a process of bonding, after the through mold via is formed, a die of an integrated circuit to a surface of the protective film in which the through mold via is formed to form a first package on a surface side where the die is bonded; and
a process of forming a second package on a surface side of the first package where the die is not bonded.

10. The method for manufacturing a semiconductor device according to claim 9, wherein
the process of forming a protective film and forming a through mold via in the protective film includes:
a process of applying an adhesive to a support substrate;
a process of forming the protective film on an upper surface of the adhesive;
a process of patterning the protective film according to a planar shape of an upper end portion of the through mold via and a planar shape of the die;
a process of forming a seed layer on an upper surface of the protective film that has been patterned; and
a process of forming a resist mask on an upper surface of the seed layer according to a shape of a lower end portion of the through mold via.

11. The method for manufacturing a semiconductor device according to claim 9, wherein
the process of forming a protective film and forming a through mold via in the protective film includes:
a process of applying an adhesive to a support substrate;
a process of forming a second re-distribution layer on an upper surface of the adhesive;
a process of forming the protective film on an upper surface of the second re-distribution layer;
a process of patterning the protective film;
a process of forming a seed layer on an upper surface of the protective film that has been patterned; and
a process of forming a resist mask on an upper surface of the seed layer according to a shape of the through mold via.

12. The method for manufacturing a semiconductor device according to claim 9, wherein
the process of bonding, after the through mold via is formed, a die of an integrated circuit to a surface of the protective film in which the through mold via is formed to form a first package on a surface side where the die is bonded includes:
a process of forming the through mold via on the protective film;
a process of bonding the die to a surface on which the through mold via is formed;
a process of forming a through electrode penetrating and connecting the die and the wiring layer of the die;
a process of filling an outer periphery of the through mold via and an outer periphery of the die with a first molding material; and
a process of forming a first re-distribution layer on a surface side where the die is not bonded.

13. The method for manufacturing a semiconductor device according to claim 9, wherein
the process of forming a second package on a surface side of the first package where the die is not bonded includes:
a process of bonding at least one another die onto a substrate and connecting a pad of the another die and a pad of the substrate;
a process of filling an outer periphery of the another die with a second molding material;
a process of forming a connection terminal on a surface side of the substrate where the another die is not bonded; and
a process of connecting the connection terminal formed in the second package and the upper end portion of the through mold via formed in the first package.

14. The method for manufacturing a semiconductor device according to claim 13, wherein
the process of connecting the connection terminal formed in the second package and the upper end portion of the through mold via formed in the first package includes:
a process of placing the second package on the first package;
a process of joining the upper end portion of the through mold via formed in the first package and the connection terminal formed in the second package together with the upper end portion of the through mold via and the connection terminal facing each other; and
a process of establishing connection by mechanical stress or mechanical stress and heating in the joined state.

15. An electronic device comprising a semiconductor device, the semiconductor device including:
a first package including
a die of an integrated circuit,
a protective film disposed on an upper surface of the die, the protective film being larger in area than the die,
a first molding material covering an outer periphery of the die,
a plurality of through mold vias formed penetrating the first molding material and the protective film, the plurality of through mold vias being smaller in penetrating diameter of the protective film than the first molding material,
a seed layer formed on upper end portions of the through mold vias and peripheral side surfaces of the through mold vias, and
an external connection terminal connected to lower end portions of the through mold vias; and
a second package placed on an upper surface of the protective film of the first package and connected to the upper end portions of the through mold vias.
